# EUROPÄISCHE PATENTSCHRIFT

(11) **EP 0 514 671 B1**
(45) Veröffentlichungstag und Bekanntmachung des Hinweises auf die Patenterteilung: **19.07.1995**
(21) Anmeldenummer: 92106723.7
(22) Anmeldetag: 18.04.1992
(51) Int. Cl.: G01R 1/067, G01R 1/04

(54) **Prüfvorrichtung**
Test appliance
Dispositif de test

(30) Priorität: 21.05.1991 DE 4116457
(43) Veröffentlichungstag der Anmeldung: 25.11.1992
(73) Patentinhaber: LANG-DAHLKE, Helmut, D-79100 Freiburg (DE)
(72) Erfinder: LANG-DAHLKE, Helmut, D-79100 Freiburg (DE)
(74) Vertreter: Goy, Wolfgang, Dipl.-Phys.

(56) Entgegenhaltungen:
- DE-A- 3 533 810
- DE-U- 8 911 411

## Beschreibung

Die Erfindung betrifft eine Vorrichtung zum Prüfen der Kontaktierung und/oder Verdrahtung von auf einer Platine in einem Feld angeordneten, insbesondere für die Kontaktierung von Steckkarten bestimmten Steckbuchsen mit einem Gehäuse, das an einander gegenüberliegenden Innenseitenwänden zueinander parallele erste Führungselemente in einem bestimmten Rastermaß aufweist, sowie mit den zu prüfenden Steckbuchsen zugeordneten und mit einer Auswerteschaltung verbundenen Testadaptern, bei denen jeweils am vorderen Ende einer flachen Kassette ein Prüfkopf insbesondere auswechselbar angeordnet ist, wobei die Kassetten mittels an den beiden Längsschmalseiten ausgebildeten zweiten Führungselementen derart in den ersten Führungselementen des Gehäuses verschiebbar sind, daß der Prüfkopf auf die jeweils zu testende Steckbuchse aufsteckbar und mit dieser kontaktierbar ist. Eine ähnliche Vorrichtung ist z.B. aus DE-U-8 911 411 bereits bekannt.

In der heutigen Mikroelektronik ist es bekannt und üblich, auf einer Platine ein Feld von Steckbuchsen in mehreren Reihen vorzusehen, um beispielsweise sogenannte Steckkarten unter Kontaktierung aufzustecken. Ein Problem besteht darin, daß man nach der Anordnung der Steckbuchsen auf der Platine nicht genau weiß, ob die Kontaktierung und/oder Verdrahtung richtig erfolgt ist. Aus diesem Grunde ist es erforderlich, eine elektrische Überprüfung durchzuführen.

Eine bekannte Testvorrichtung sieht eine entsprechend der Anzahl der zu testenden Steckbuchsen Anzahl von Testadaptern vor. Diese weisen eine Kassette auf, an derem vorderen Ende ein Prüfkopf vorzugsweise auswechselbar angeordnet ist. Um die Leitungswege zwischen dem Prüfkopf und dem Meßgerät zu reduzieren, ist die Schaltungselektronik in der Kassette des Testadapters integriert. Alternativ ist es auch möglich, in der Kassette nur die Verdrahtung vorzusehen, während die Schaltelektronik extern ist. Der Prüfkopf ist mit Steckelementen oder Federkontaktstiften bestückt und wird mit diesen Kontaktierelementen auf die entsprechende Steckbuchse für die Testmessungen aufgesteckt. Zu diesem Zweck ist ein der Platine mit dem Steckbuchsenfeld zugeordnetes Gehäuse vorgesehen. Dieses weist an einander gegenüberliegenden Innenseitenwänden in einem vorgegebenen Rastermaß zueinander parallele Führungsnuten auf. Durch die entsprechende Teilung ist ein durchgängiges Rasterfeld geschaffen. Korrespondierend zu diesen Führungsnuten an den einander gegenüberliegenden Innenseitenwänden des Gehäuses weisen die Testadapter im Bereich der Längsschmalseiten Längsstege auf, mittels denen die Testadapter in den Führungsnuten in das Gehäuse einschiebbar sind. Da die Führungsnuten ein Rasterfeld bilden, sind die Positionen der Testadapter an unterschiedliche Prüflingsaufbauten anpaßbar.

Ein Nachteil bei der bekannten Testvorrichtung besteht darin, daß zum Verschieben der Testadapter zur Anpassung an einen anderen Prüflingsaufbau diese Testadapter vollständig aus den Führungsnuten und damit aus dem Gehäuse herausgezogen werden müssen, um sie anschließend in der neuen Position wieder hineinzustecken. Dies ist insofern nachteilig, als daß am oberen Ende der Testadapter Meßkabel angeordnet sind, welche das Herausziehen der Testadapter erschweren und umständlich gestalten. Ein weiterer Nachteil bei der bekannten Testvorrichtung liegt darin, daß die Testadapter nur jeweils um das vorgegebene Rastermaß verschoben werden können. Dieses Rastermaß, welches durch die Führungsnuten im Gehäuse definiert ist, kann jedoch nicht zu klein gemacht werden, da ansonsten die Zwischenstege zwischen den Führungsnuten zu dünn würden.

Davon ausgehend liegt der Erfindung die **Aufgabe** zugrunde, die bekannte Prüfvorrichtung derart weiterzuentwickeln, daß auf einfachere Weise die Testadapter neu positioniert werden können.

Als technische **Lösung** wird mit der Erfindung vorgeschlagen, daß zwischen der einen Längsschmalseite der Kassette und der benachbarten Innenseitenwand des Gehäuses eine Zwischenleiste eingeschoben ist, wobei ein drittes Führungselement der Zwischenleiste korrespondierend in das erste Führungselement des Gehäuses eingreift und wobei in ein bezüglich des dritten Führungselements entgegengesetzt gerichtetes viertes Führungselement der Zwischenleiste korrespondierend das zweite Führungselement der Kassette eingreift.

Eine nach dieser technischen Lehre ausgebildete Prüfvorrichtung hat den Vorteil, daß die Testadapter zur Anpassung an einen neuen Prüflingsaufbau problemlos verschoben werden können, ohne daß die Testadapter aus dem System genommen werden müssen. Es ist lediglich erforderlich, die jeweilige Zwischenleiste herauszuziehen, so daß der zugehörige Testadapter frei wird und in die gewünschte Position entsprechend der vorgegebenen Rasterschrittweite verschoben werden kann. Dadurch ist die Prüfvorrichtung sehr rasch und leicht an unterschiedliche Prüflinge anpaßbar, ohne daß dies eine umständliche Handhabung der Testadapter erfordert.

In einer bevorzugten Weiterbildung wird vorgeschlagen, daß die ersten Führungselemente Führungsnuten, die zweiten Führungselemente Längsstege, die dritten Führungselemente Stege und die vierten Führungselemente Nuten sind. Selbstverständlich können die vier Führungselemente auch anders ausgebildet sein.

Während in der Grundversion jedem Testadapter eine einzige Zwischenleiste zugeordnet ist, indem nach Herausziehen dieser Zwischenleiste der Testadapter erst in seiner Ebene verschoben werden muß, um ihn anschließend senkrecht hierzu in die neue Position verschieben zu können, wird in einer bevorzugten Weiterbildung vorgeschlagen, daß an beiden Längsschmalseiten der Kassette jeweils eine Zwischenleiste eingeschoben Ist. In diesem Fall müssen zum Verschieben des jeweiligen Testadapters in die neue Position die beiden Zwischenleisten herausgezogen werden, um sie anschließend in der neuen Position wieder einzufügen.

In einer Weiterbildung der Zwischenleiste wird vorgeschlagen, daß das dritte Führungselement auf der einen Seite und das vierte Führungselement auf der anderen Seite einer Basisplatte der Zwischenleiste angeordnet ist. Diese Basisplatte bildet dabei gewissermaßen eine Anlagefläche an der entsprechenden Innenseitenwand des Gehäuses.

In einer bevorzugten Weiterbildung wird vorgeschlagen, daß das vierte Führungselement bezüglich des dritten Führungselements seitlich versetzt ist. Diese Weiterbildung bringt den Vorteil mit sich, daß die Positionierung der Testadapter nicht auf die Positionen der ersten Führungselemente im Gehäuse beschränkt ist, sondern daß durch einen entsprechenden Versatz in der Zwischenleiste auch Zwischenpositionen für die Testadapter eingenommen werden können. Dadurch ist die Testvorrichtung auf sehr einfache Weise an prüflingsspezifische Sonderteilungen und -abstände problemlos anpaßbar.

In einer bevorzugten Weiterbildung hiervon wird vorgeschlagen, daß der Versatz ein Viertel des Rastermaßes beträgt, wobei vorzugsweise die Zwischenleiste sowohl mit ihrem einen Ende als auch mit ihrem anderen Ende gleichermaßen einschiebbar ist. Dies bringt den enormen Vorteil mit sich, daß mittels einer derartig ausgebildeten Zwischenleiste jede Position im halben Rastermaß erreicht werden kann. Die Anwendung der Testvorrichtung ist somit also nicht auf das durch die ersten Führungselemente im Gehäuse vorgegebene Rastermaß beschränkt, sondern mittels der speziell ausgebildeten Zwischenleisten wird das Rastermaß halbiert. Das kann mit ein und derselben Zwischenleiste erreicht werden, da diese mit ihren beiden Enden gleichermaßen einschiebbar ist.

In einer bevorzugten Weiterbildung der Zwischenleiste ist diese ein Aluminiumprofil, so daß sie sich auf technisch einfache Weise herstellen läßt.

Eine weitere Weiterbildung der Zwischenleiste schlägt vor, daß diese endseitig eine Lochung aufweist. Somit kann die Zwischenleiste mit einem entsprechenden Ziehwerkzeug beispielsweise in Form einer Zange leicht herausgezogen werden.

Eine weitere bevorzugte Weiterbildung schlägt vor, daß auf die oberen Enden der längs einer Gehäusewand hintereinander angeordneten Zwischenleisten eine Verbindungsleiste derart formschlüssig aufschiebbar ist, daß die Zwischenleisten mittels der aufgeschobenen Verbindungsleiste nach oben aus dem Gehäuse herausziehbar sind. Der Vorteil dieser Weiterbildung ist, daß sämtliche Zwischenleisten auf der einen Seite des Gehäuses mittels der Verbindungsleiste gleichzeitig nach oben herausgezogen werden können, so daß auf schnelle und einfache Weise eine neue Anordnung der Testadapter innerhalb des Gehäuses für einen neuen Anwendungsfall möglich ist. Soll nur eine einzige Zwischenleiste aus dem Gehäuse herausgezogen werden, so wird die Verbindungsleiste entsprechend so verschoben, daß die herauszunehmende Zwischenleiste frei liegt und dadurch separat aus dem Gehäuse herausgezogen werden kann. Dies vereinfacht die Handhabung beträchtlich. Damit die Zwischenleisten sicher innerhalb des Gehäuses gehalten werden, ist vorzugsweise eine Fixiereinrichtung für die Verbindungsleisten vorgesehen. Dies kann beispielsweise ein am Gehäuse angeordneter Bügel sein.

Eine weitere Weiterbildung schlägt vor, daß die ersten Führungselemente für die Zwischenleisten an den Innenseitenwänden des Gehäuses in insbesondere aneinanderreihbaren Platten insbesondere aus Aluminium ausgebildet sind. Derartige Platten lassen sich auf technisch einfache Weise herstellen, so daß eine individuelle Bestückung des Gehäuses möglich ist. Insbesondere ist dadurch ein variables Baukastensystem geschaffen.

Eine weitere bevorzugte Weiterbildung der Erfindung schlägt einen dem jeweiligen Testadapter zugeordneten Pneumatikantrieb vor, welcher den Testadapter längs der Zwischenleisten in die Kontaktierstellung sowie gegebenenfalls in die Entkontaktierstellung überführt. Dieser Pneumatikantrieb bringt den Vorteil mit sich, daß der Testadapter wie von Hand dosiert auf die zu testende Steckbuchse aufgeschoben werden kann, ohne daß die Gefahr besteht, daß die dabei auftretenden Kräfte zu groß werden, da die Platinen sehr zerbrechlich sind und bei einer großen Kraftausübung zerbrechen würden. Selbstverständlich vereinfacht der Pneumatikantrieb auch die Handhabung der Prüfvorrichtung.

In einer Weiterbildung hiervon wird vorgeschlagen, daß ein Zylindergehäuse des Pneumatikantriebs lösbar am Gehäuse und ein Kolben des Pneumatikantriebs fest am Testadapter angeordnet ist. Dies bringt zum einen den Vorteil mit sich, daß mittels des Pneumatikantriebs der Testadapter sowohl in die Kontaktierstellung als auch in die Entkontaktierstellung auf technisch einfache Weise übergeführt werden kann. Der Pneumatikantrieb bildet dabei eine feste Einheit mit der Kassette des Testadapters, d.h. ist fest mit dieser verbunden. Da aber der Pneumatikantrieb lösbar am Gehäuse angeordnet ist, kann nach Lösen des Pneumatikantriebs sowie nach herausziehen der Zwischenleisten eine neue Positionierung der Testadapter erreicht werden.

Dabei ist in einer Weiterbildung das Zylindergehäuse des Pneumatikantriebs in der Art eines Bajonettverschlusses lösbar am Gehäuse angeordnet. Dies bedeutet, daß beispielsweise in Längsrichtung des Gehäuses verlaufende Schienen vorgesehen sind, in denen nach einer Drehbewegung die Pneumatikantriebe mit entsprechenden Fortsätzen formschlüssig zu liegen kommen. Dadurch ist es möglich, auf überaus schnelle Weise die Pneumatikantriebe und damit die Testadapter zu lösen.

Zwei Ausführungsbeispiele der erfindungsgemäßen Prüfvorrichtung werden nachfolgend anhand der Zeichnungen beschrieben. In diesen zeigt:
- Fig. 1: eine schematische Draufsicht auf eine erste Ausführungsform der Prüfvorrichtung;
- Fig. 2: eine Seitenansicht der Prüfvorrichtung in Fig. 1;
- Fig. 3: eine schematische Seitenansicht einer zweiten Ausführungsform der Prüfvorrichtung;
- Fig. 4: ein vergrößerter Detailausschnitt der Prüfvorrichtung in Fig. 3;
- Fig. 5: eine zu Fig. 3 senkrechte Ansicht der Prüfvorrichtung.

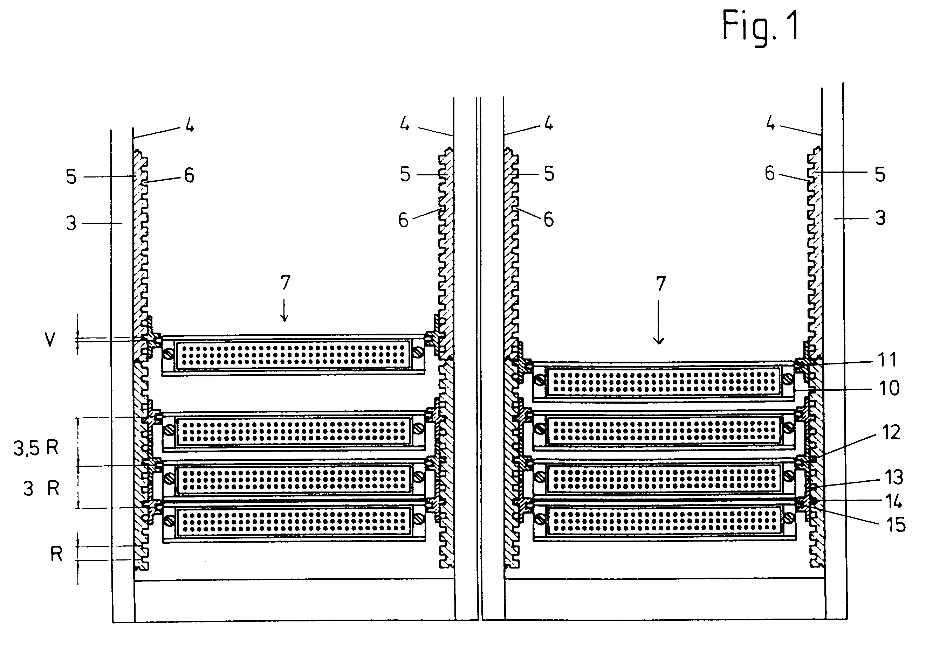

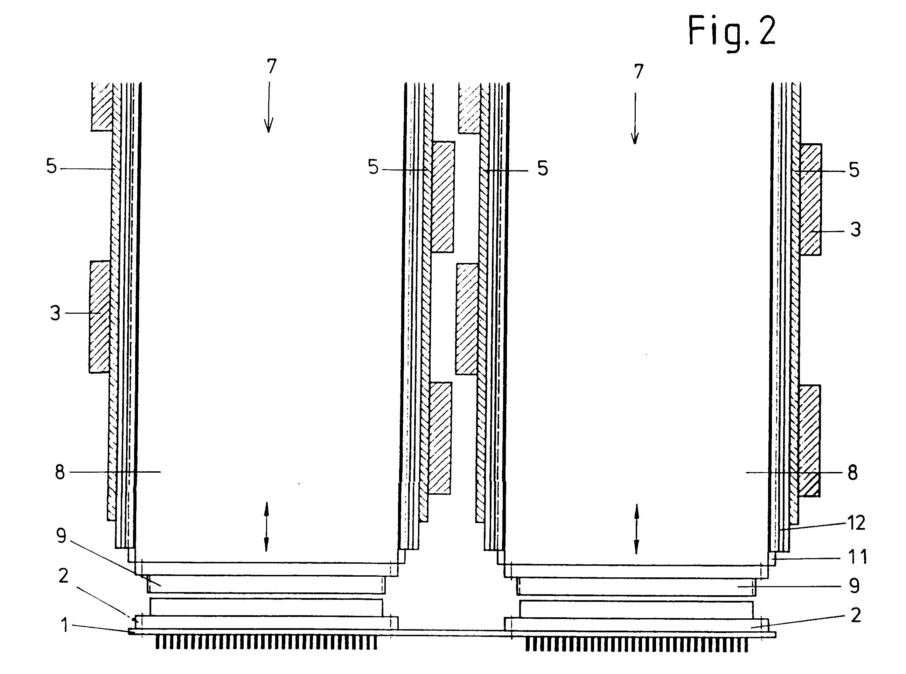

Die in Fig. 1 und 2 dargestellte erste Ausführungsform einer Testvorrichtung zum Prüfen der Kontaktierung und/oder Verdrahtung von auf einer Platine 1 in einem zweireihigen Feld angeordneten Steckbuchsen 2, die beispielsweise der Kontaktierung von aufsteckbaren Steckkarten dienen, weist zwei im wesentlichen quaderförmige Gehäuse 3 auf, wobei das eine Gehäuse 3 der einen Reihe und das andere Gehäuse 3 der anderen Reihe der Steckbuchse 2 zugeordnet ist. An den beiden in Längsrichtung sich erstreckenden, einander gegenüberliegenden Innenseitenwänden 4 eines jedes Gehäuses 3 sind Platten 5 aus Aluminium aneinandergereiht angeordnet. Diese Platten 5 sind mit zueinander parallelen Führungsnuten 6 versehen. Diese bilden ein Rasterfeld mit einem bestimmten Rastermaß R, welches beispielsweise 5,08 mm betragen kann.

In den Gehäusen 3 sind Testadapter 7 angeordnet, mittels denen die Steckbuchsen 2 überprüft werden. Diese Testadapter 7 weisen jeweils eine im wesentlichen quaderförmige Kassette 8 zur Aufnahme der Schaltelektronik oder alternativ zur Aufnahme lediglich der Verdrahtung mit extern angeordneter Schaltelektronik sowie am vorderen Ende einen insbesondere auswechselbaren Prüfkopf 9 auf, der mit Steckelementen oder Federkontaktstiften bestückt ist, die die elektrische Verbindung zu den korrespondierenden Kontakten der zu prüfenden Steckbuchse 2 bilden. An den beiden Längsschmalseiten 10 weisen die Kassetten 8 jeweils Längsstege 11 auf.

Um die Testadapter 7 innerhalb der Gehäuse 3 an den gewünschten Stellen zu positionieren, sind schienenartige Zwischenleisten 12 vorgesehen. Diese weisen eine Basisplatte 13 auf, an deren einen Seite sich ein Steg 14 und auf der gegenüberliegenden Seite eine Nut 15 befindet. Zwischen dem Steg 14 und der Nut 15 existiert ein seitlicher Versatz V, der ein Viertel des Rastermaßes R beträgt.

Zum Positionieren der Testadapter 7 innerhalb der Gehäuse 3 werden die Zwischenleisten 12 von oben zwischen den beiden Längsschmalseiten 10 der Kassette und den jeweils gegenüberliegenden Platten 5 derart eingeschoben, daß der Steg 14 der Zwischenleiste in der Führungsnut 6 der Platte 5 und der Längssteg 11 der Kassette 8 in der Nut 15 der Zwischenleiste 12 korrespondierend zu liegen kommt. Wie in den Zeichnungen erkennbar ist, kann dabei die Zwischenleiste 12 entweder mit ihrem einen Ende oder mit ihrem anderen Ende voran eingeschoben werden. Das Ergebnis ist, daß der Versatz V der Nut 15 bezüglich des Steges 14 der Zwischenleiste 12 in der Zeichnung einmal nach links und zum anderen nach rechts gerichtet ist. Da aber der Versatz V ein Viertel des Rastermaßes R beträgt, kann jede Position im halben Rastermaß R erreicht werden. So sind in den Zeichnungen zwei benachbarte Testadapter 7 angedeutet, die einen Abstand mit dem 3-fachen Rastermaß aufweisen, während daneben die Testadapter 7 einen Abstand mit dem 3,5-fachen Rastermaß aufweisen. Durch entsprechendes Hineinstecken der Zwischenleisten 12 entweder mit dem einen oder mit dem anderen Ende voran können somit die Testadapter 7 im halben Rastermaß R innerhalb der Gehäuse 3 positioniert werden.

Die Vorrichtung funktioniert wie folgt:

Zum Testen der Steckbuchsen 2 werden die beiden Gehäuse 3 oberhalb der Platine 1 mit den Steckbuchsen 2 angeordnet. Sofern die Testadapter 7 ihre bezüglich der Steckbuchsen 2 richtigen Positionen haben, werden sie pneumatisch derart nach unten verschoben, daß die entsprechenden Prüfköpfe 9 auf den Steckbuchsen 2 aufgesteckt werden und die elektrische Kontaktierung herstellen, so daß die entsprechenden Prüfmessungen durchgeführt werden können. Nach erfolgter Prüfung werden dann die Testadapter 7 wieder hochgefahren.

Sofern eine Platine 1 mit einer anderen Anordnung der Steckbuchsen 2 getestet werden soll, müssen die Testadapter 7 entsprechend in ihren Gehäusen 3 verschoben werden. Hierzu ist es lediglich erforderlich, die beiden Zwischenleisten 12 des zu verschiebenden Testadapters 7 nach oben herauszuziehen, um anschließend den Testadapter 7 innerhalb des Gehäuses 3 verschieben zu können, ohne daß der Testadapter 7 selbst aus dem Gehäuse 3 herausgezogen werden muß. Nach dem Verschieben des Testadapters 7 in die richtige Position brauchen dann lediglich noch die beiden Zwischenleisten 12 wieder mit dem Versatz in der richtigen Richtung hineingesteckt werden.

In dem dargestellten Ausführungsbeispiel weist das Gehäuse 3 an seinen Innenseitenwänden 4 Führungsnuten 6 und die Testadapter 7 weisen Längsstege 11 auf. Dazu korrespondierend weisen die Zwischenleisten 12 Stege 14 und Nuten 15 auf. Es ist gleichermaßen auch denkbar, daß diese Teile die unterschiedlichsten Nut/Steg-, Nut/Nut- sowie Steg/Steg-Kombinationen aufweisen. Es ist lediglich erforderlich, daß zwischen den Testadaptern 7, den Zwischenleisten 12 und den Innenseitenwänden 4 des Gehäuses 3 miteinander korrespondierende Führungselemente in Form von Nuten oder Stegen ausgebildet sind.

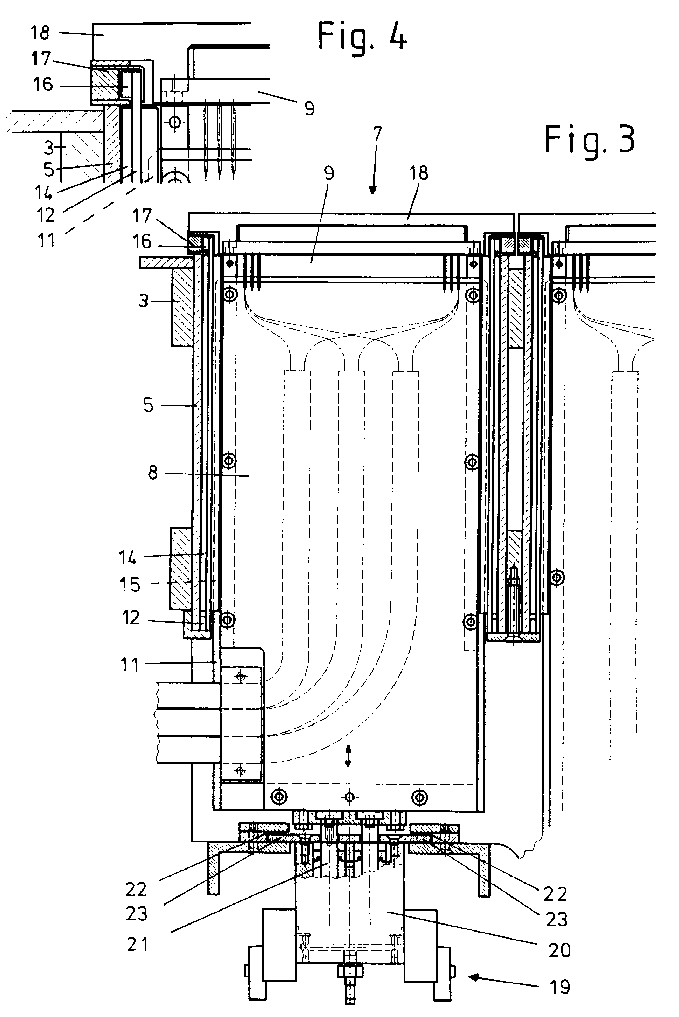

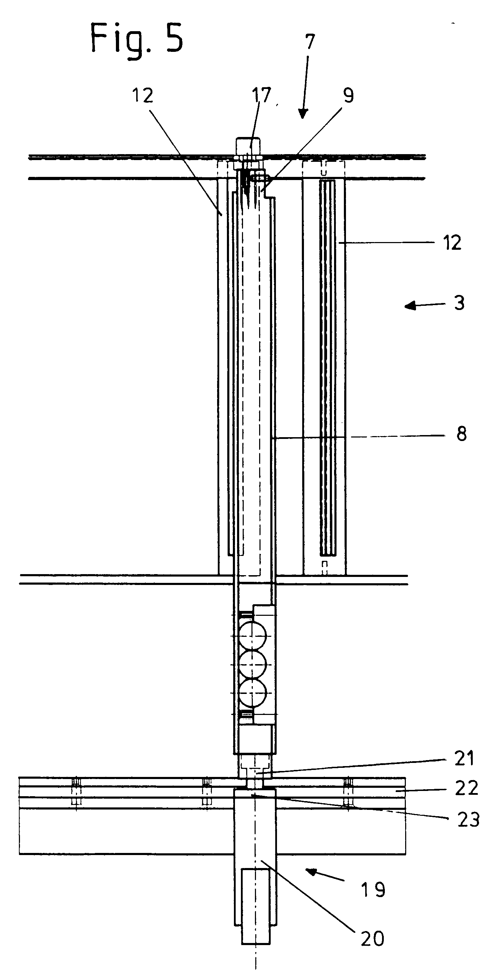

In den Fig. 3 bis 5 ist eine zweite Ausführungsform einer Testvorrichtung dargestellt. Diese unterscheidet sich von der ersten Ausführungsform in Fig. 1 und 2 lediglich in zwei Punkten und stellt dabei eine weiterentwikkelte Version dar, so daß nachfolgend nur auf diese beiden Punkte eingegangen werden soll, während die anderen konstruktiven Einzelheiten mit denen der ersten Ausführungsform im wesentlichen übereinstimmen.

Wie insbesondere in der Darstellung gemäß Fig. 4 erkennbar ist, weisen die Zwischenleisten 12 an ihrem oberen Ende jeweils eine nach außen hin auskragende Nase 16 auf, wobei diese Nasen 16 der auf einer Seite des Gehäuses 3 angeordneten Zwischenleisten 12 miteinander fluchten. Auf die so jeweils mit einer Nase 16 ausgestatteten oberen Enden der Zwischenleisten 12 ist längs der Gehäusewand eine Verbindungsleiste 17 aufgeschoben und verbindet diese miteinander. Dabei ist in Fig. 4 erkennbar, daß die Verbindungsleiste 17 die Nasen 16 der Zwischenleisten 12 untergreift, so daß in Längsrichtung der Zwischenleisten 12 gesehen ein Formschluß geschaffen ist. Dies bedeutet, daß beim Nachobenziehen der Verbindungsleiste 17 sämtliche aufgeschobenen Zwischenleisten 12 formschlüssig mitgenommen und aus dem Gehäuse 3 herausgezogen werden. Dadurch ist es möglich, auf schnelle und einfache Weise sämtliche Zwischenleisten 12 aus dem Gehäuse 3 herauszuziehen, um so beispielsweise eine Neupositionierung der Testadapter 7 vornehmen zu können. Soll nur eine ganz bestimmte Zwischenleiste 12 herausgezogen werden, so wird die Verbindungsleiste 17 solange verschoben, bis die Zwischenleiste 12 frei liegt und daher separat für sich alleine herausgezogen werden kann. Zur Sicherung der Verbindungsleiste 17 am Gehäuse 3 und damit zur Lagefixierung der Zwischenleisten 12 ist eine gehäusefeste Fixiereinrichtung 18 vorgesehen, weiche verhindert, daß die Verbindungsleiste 17 nach oben bewegt werden kann, die aber bei Bedarf entfernbar ist.

Weiterhin ist den Testadaptern 7 jeweils ein Pneumatikantrieb 19 zugeordnet. Dieser Pneumatikantrieb 19 weist ein Zylindergehäuse 20 sowie einen Kolben 21 auf. Dabei ist der Kolben 21 fest an der Unterseite der Kassette 8 befestigt, während das Zylindergehäuse 20 des Pneumatikantriebs 19 in der Betriebsstellung zwar fest, ansonsten jedoch lösbar im Boden des Gehäuses 3 angeordnet ist. Zu diesem Zweck weist der Gehäuseboden zwei in Längsrichtung verlaufende Nuten 22 auf, die - wie in Fig. 3 erkennbar ist - aufeinander zu gerichtet sind. Korrespondierend zu den Nuten 22 weist das Zylindergehäuse 20 voneinander weggerichtete Flügel 23 auf. Diese sind derart ausgebildet, daß sie in der Art eines Bajonettverschlusses in die Nuten 22 eingesetzt werden können. Zu diesem Zweck wird die Einheit bestehend aus dem Testadapter 7 und dem Pneumatikantrieb 19 etwas verdreht in das Gehäuse 3 eingesetzt, so daß die Flügel 23 des Zylindergehäuses 20 noch außerhalb der Nuten 22, jedoch benachbart zu diesen liegen. Durch eine Drehbewegung kommen dann die Flügel 23 in den Nuten 22 zu liegen, so daß sie in Längsrichtung der Zwischenleisten 12 gesehen formschlüssig darin gehalten sind. Diese Arbeitsstellung ist in den Zeichnungen dargestellt.

Durch eine Betätigung des Pneumatikantriebs 19 wird der Testadapter 7 in Fig. 3 nach oben verschoben, so daß die entsprechende Kontaktierung erfolgt. Der Pneumatikantrieb 19 kann dabei derart gesteuert werden, daß die Kontaktierung "wie von Hand" erfolgt, ohne daß bei der Kontaktierung die auftretenden Kräft auf die Platine 1 zu groß werden und diese möglicherweise zerbricht. Für die Entkontaktierung wird der Kolben 21 des Pneumatikantriebs 19 in die andere Richtung bewegt. Sollen die Testadapter 7 aus dem Gehäuse 3 entfernt werden, so ist es lediglich nach Entfernen der Zwischenleisten 12 erforderlich, die Testadapter/Pneumatikantrieb-Einheit 7, 19 etwas um ihre Längsachse zu verdrehen, so daß die Flügel 23 frei werden und somit die Einheit aus dem Gehäuse 3 entfernt werden kann.

### Bezugszeichenliste

- 1: Platine
- 2: Steckbuchse
- 3: Gehäuse
- 4: Innenseitenwand
- 5: Platte
- 6: Führungsnut
- 7: Testadapter
- 8: Kassette
- 9: Prüfkopf
- 10: Längsschmalseite
- 11: Längssteg
- 12: Zwischenleiste
- 13: Basisplatte
- 14: Steg
- 15: Nut
- 16: Nase
- 17: Verbindungsleiste
- 18: Fixiereinrichtung
- 19: Pneumatikantrieb
- 20: Zylindergehäuse
- 21: Kolben
- 22: Nut
- 23: Flügel
- R: Rastermaß
- V: Versatz

## Patentansprüche

1. Vorrichtung zum Prüfen der Kontaktierung und/oder Verdrahtung von auf einer Platine (1) in einem Feld angeordneten, insbesondere für die Kontaktierung von Steckkarten bestimmten Steckbuchsen (2)
mit einem Gehäuse (3), das an einander gegenüberliegenden Innenseltenwänden (4) zueinander parallele erste Führungselemente (6) in einem bestimmten Rastermaß (R) aufweist,
sowie mit den zu prüfenden Steckbuchsen (2) zugeordneten und mit einer Auswerteschaltung verbundenen Testadaptern (7), bei denen jeweils am vorderen Ende einer flachen Kassette (8) ein Prüfkopf (9) insbesondere auswechselbar angeordnet ist, wobei die Kassetten (8) mittels an den beiden Längsschmalseiten (10) ausgebildeten zweiten Führungselementen (11) derart in den ersten Führungselementen (6) des Gehäuses (3) verschiebbar sind, daß der Prüfkopf (9) auf die jeweils zu testende Steckbuchse (2) aufsteckbar und mit dieser kontaktierbar ist,
**dadurch gekennzeichnet**,
daß zwischen der einen Längsschmalseite (10) der Kassette (8) und der benachbarten Innenseitenwand (4) des Gehäuses (3) eine Zwischenleiste (12) eingeschoben ist, wobei ein drittes Führungselement (14) der Zwischenleiste (12) korrespondierend in das erste Führungselement des Gehäuses (3) eingreift und wobei in ein bezüglich des dritten Führungselements entgegengesetzt gerichtetes viertes Führungselement (15) der Zwischenleiste (12) korrespondierend das zweite Führungselement (15) der Kassette (8) eingreift.

2. Vorrichtung nach Anspruch 1, dadurch gekennzeichnet, daß die ersten Führungselemente Führungsnuten (6), die zweiten Führungselemente Längsstege (11), die dritten Führungselemente Stege (14) und die vierten Führungselemente Nuten (15) sind.

3. Vorrichtung nach Anspruch 1 oder 2, dadurch gekennzeichnet, daß an beiden Längsschmalseiten (10) der Kassette (8) jeweils eine Zwischenleiste (12) eingeschoben ist.

4. Vorrichtung nach einem der Ansprüche 1 bis 3, dadurch gekennzeichnet, daß das dritte Führungselement (14) auf der einen Seite und das vierte Führungselement (15) auf der anderen Seite einer Basisplatte (13) der Zwischenleiste (12) angeordnet ist.

5. Vorrichtung nach einem der Ansprüche 1 bis 4, dadurch gekennzeichnet, daß das vierte Führungselement bezüglich des dritten Führungselements seitlich versetzt ist.

6. Vorrichtung nach Anspruch 5, dadurch gekennzeichnet, daß der Versatz (V) ein Viertel des Rastermaßes (R) beträgt, wobei vorzugsweise die Zwischenleiste (12) sowohl mit ihrem einen Ende als auch mit ihrem anderen Ende gleichermaßen einschiebbar ist.

7. Vorrichtung nach einem der Ansprüche 1 bis 6, dadurch gekennzeichnet, daß die Zwischenleiste (12) ein Aluminiumprofil ist.

8. Vorrichtung nach einem der Ansprüche 1 bis 7, dadurch gekennzeichnet, daß die Zwischenleiste (12) endseitig eine Lochung aufweist.

9. Vorrichtung nach einem der Ansprüche 1 bis 8, dadurch gekennzeichnet, daß auf die oberen Enden der längs einer Gehäusewand hintereinander angeordneten Zwischenleisten (12) eine Verbindungsleiste (17) derart formschlüssig aufschiebbar ist, daß die Zwischenleisten (12) mittels der aufgeschobenen Verbindungsleiste (17) nach oben aus dem Gehäuse (3) herausziehbar sind.

10. Vorrichtung nach einem der Ansprüche 1 bis 9, dadurch gekennzeichnet, daß die ersten Führungselemente für die Zwischenleisten (12) an den Innenseitenwänden (4) des Gehäuses (3) in insbesondere aneinanderreihbaren Platten (5) insbesondere aus Aluminium ausgebildet sind.

11. Vorrichtung nach einem der Ansprüche 1 bis 10, gekennzeichnet durch einen dem jeweiligen Testadapter (7) zugeordneten Pneumatikantrieb (19), welcher den Testadapter (7) längs der Zwischenleisten (12) in die Kontaktierstellung sowie gegebenenfalls in die Entkontaktierstellung überführt.

12. Vorrichtung nach Anspruch 11, dadurch gekennzeichnet, daß ein Zylindergehäuse (20) des Pneumatikantriebs (19) lösbar am Gehäuse (3) und ein Kolben (21) des Pneumatikantriebs (19) fest am Testadapter (7) angeordnet ist.

13. Vorrichtung nach Anspruch 12, dadurch gekennzeichnet, daß das Zylindergehäuse (20) des Pneumatikantriebs (19) in der Art eines Bajonettverschlusses lösbar am Gehäuse (3) angeordnet ist.

## Claims

1. Device for testing the contacts and/or wiring of sockets (2) arranged in a field on a board (1) and intended in particular for making contact with plug-in cards (2),
with a housing (3) with first guide elements (6) running parallel to each other on opposite inner side walls (4) in a certain modular dimension (R),
and with test adapters (7) allocated to the sockets (2) to be tested and connected to an evaluation circuit, where a test head (9) is arranged in particular to be exchangeable on the front end of a flat cassette (8) of each said adapter (7), where the cassettes (8) can be displaced in the first guide elements (6) of the housing (3) by means of second guide elements (11) formed on the two long narrow sides (10) such that the test head (9) can plug into and make contact with the socket (2) to be tested,
characterised in that
between one long narrow side (10) of the cassette (8) and the adjacent inner side wall (4) of the housing (3) is inserted a spacer strip (12), where a third guide element (14) of the spacer strip (12) engages correspondingly in the first guide element of the housing (3) and where the second guide element of the cassette (8) engages correspondingly in a fourth guide element (15) of the spacer strip (12) aligned opposite the third guide element.

2. Device according to Claim 1, characterised in that the first guide elements are guide grooves (6), the second guide elements are longitudinal ridges (11), the third guide elements are ridges (14) and the fourth guide elements are grooves (15).

3. Device according to Claim 1 or 2, characterised in that a spacer strip (12) is inserted on both long narrow sides (10) of the cassette (8).

4. Device according to any of Claims 1 to 3, characterised in that the third guide element (14) is arranged on one side and the fourth guide element (15) on the other side of a base plate (13) of the spacer strip (12).

5. Device according to any of Claims 1 to 4, characterised in that the fourth guide element is offset sideways in relation to the third guide element.

6. Device according to Claim 5, characterised in that the offset (V) amounts to one quarter of the modular dimension (R), where preferably the spacer strip (12) can be inserted equally well with its one end as with its other.

7. Device according to any of Claims 1 to 6, characterised in that the spacer strip (12) is an aluminium profile.

8. Device according to any of Claims 1 to 7, characterised in that the spacer strip (12) has a hole at the end.

9. Device according to any of Claims 1 to 8, characterised in that a connecting strip (17) can be pushed tightly onto the upper ends of the spacer strips (12) arranged behind each other along a housing wall such that the spacer strips (12) can be withdrawn upwards out of the housing (3) by means of the attached connecting strip (17).

10. Device according to any of Claims 1 to 9, characterised in that the first guide elements for the spacer strips (12) on the inner side walls (4) of the housing (3), arranged in particular in panels (5) which can be stacked in rows, are formed in particular of aluminium.

11. Device according to any of Claims 1 to 10, characterised by a pneumatic drive (19) allocated to each test adapter (7) which moves the test adapter (7) along the spacer strips (12) into the contact position and also out of the contact position.

12. Device according to Claim 11, characterised in that a cylinder housing (20) of the pneumatic drive (19) is arranged removably on the housing (3) and a piston (21) of the pneumatic drive (19) is arranged permanently on the test adapter (7).

13. Device according to Claim 12, characterised in that the cylinder housing (20) of the pneumatic drive (19) is arranged removably on the housing (3) with a type of bayonet fitting.

## Revendications

1. Dispositif de contrôle de la mise en contact et/ou du câblage de fiches femelles (2), disposées dans un champ sur une plaquette (1) et notamment destinées à la mise en contact de cartes enfichables, avec un boîtier (3), présentant sur des parois latérales internes opposées (4) des premiers éléments de guidage (6), parallèles entre eux, dans un module défini (R), et avec des adaptateurs d'essai (7), associés aux fiches femelles (2) à contrôler et reliés à un circuit d'analyse, adaptateurs sur lesquels une tête de contrôle (9), interchangeable notamment, est respectivement disposée sur l'extrémité avant d'une cassette plate (8), les cassettes (8) pouvant se déplacer dans les premiers éléments de guidage (16) du boîtier (3) au moyen de deuxièmes éléments de guidage (11), réalisés sur les deux petits côtés longitudinaux (10), de sorte que la tête de contrôle (9) peut être emmanchée sur la fiche femelle (2) respective à tester et peut être mise en contact avec cette dernière, caractérisé en ce qu'une barrette intermédiaire (12) est insérée entre l'un des petits côtés longitudinaux (10) de la cassette (8) et la paroi latérale interne adjacente (4) du boîtier (3), un troisième élément de guidage (14) de la barrette intermédiaire (12) s'engageant d'une manière correspondante dans le premier élément de guidage du boîtier (3), et le deuxième élément de guidage de la cassette (8) s'engageant d'une manière correspondante dans un quatrième élément de guidage (15), orienté en sens inverse par rapport au troisième élément de guidage.

2. Dispositif suivant la revendication 1, caractérisé en ce que les premiers éléments de guidage sont des rainures (6), les deuxièmes éléments de guidage des profils longitudinaux (11), les troisièmes éléments de guidage des barrettes (14), et les quatrièmes éléments de guidage des rainures (15).

3. Dispositif suivant l'une des revendications 1 ou 2, caractérisé en ce qu'une barrette intermédiaire (12) est respectivement insérée sur les deux petits côtés Longitudinaux (10) de la cassette (8).

4. Dispositif suivant l'une quelconque des revendications 1 à 3, caractérisé en ce que le troisième élément de guidage (14) est disposé sur un côté et le quatrième élément de guidage (15) sur l'autre côté d'une plaque de base (13) de la barrette intermédiaire (12).

5. Dispositif suivant l'une quelconque des revendications 1 à 4, caractérisé en ce que le quatrième élément de guidage est en déport latéral par rapport au troisième élément de guidage.

6. Dispositif suivant la revendication 5, caractérisé en ce que le déport (V) équivaut à un quart du module (R), la barrette intermédiaire (12) pouvant être insérée, de préférence, aussi bien par l'une de ses extrémités que par l'autre.

7. Dispositif suivant l'une quelconque des revendications 1 à 6, caractérisé en ce que la barrette intermédiaire (12) est un profilé d'aluminium.

8. Dispositif suivant l'une quelconque des revendications 1 à 7, caractérisé en ce que la barrette intermédiaire (12) présente une perforation côté extrême.

9. Dispositif suivant l'une quelconque des revendications 1 à 8, caractérisé en ce qu'une barrette de jonction (17) peut être engagée mécaniquement sur les extrémités supérieures des barrettes intermédiaires (12), disposées les unes derrière les autres le long d'une paroi du boîtier, de sorte que les barrettes intermédiaires (12) peuvent être retirées du boîtier (3) vers le haut au moyen de la barrette de jonction (17) engagée.

10. Dispositif suivant l'une quelconque des revendications 1 à 9, caractérisé en ce que les premiers éléments de guidage pour les barrettes intermédiaires (12) sont réalisés sur les parois latérales internes (4) du boîtier (3), dans des plaques juxtaposables (5) en particulier, en aluminium notamment.

11. Dispositif suivant l'une quelconque des revendications 1 à 10, caractérisé par une commande pneumatique (19), associée à l'adaptateur d'essai (7) respectif, qui amène l'adaptateur (7) le long des barrettes intermédiaires (12) dans la position de mise en contact et, le cas échéant, dans la position de mise hors contact.

12. Dispositif suivant la revendication 11, caractérisé en ce qu'un corps de cylindre (20) de la commande pneumatique (19) est disposé d'une manière amovible sur le boîtier (3), un piston (21) de la commande pneumatique (19) ayant une disposition fixe sur l'adaptateur d'essai (7).

13. Dispositif suivant la revendication 12, caractérisé en ce que le corps de cylindre (20) de la commande pneumatique (19) a une disposition amovible sur le boîtier (3) à la manière d'un joint à baïonnette.
